# FASCICULE DE BREVET EUROPEEN

(11) **EP 1 079 432 B1**
(45) Date de publication et mention de la délivrance du brevet: **14.07.2004**
(21) Numéro de dépôt: 00402353.7
(22) Date de dépôt: 24.08.2000
(51) Int. Cl.: H01L 23/473, H01L 23/14, H05K 1/02

(54) **Module électronique et procédé de fabrication d'un tel module**
Elektronisches Modul und Herstellungsverfahren eines solchen Moduls
Electronic module and method of manufacturing such a module

(30) Priorité: 26.08.1999 FR 9910815
(43) Date de publication de la demande: 28.02.2001
(73) Titulaire: Johnson Controls Automotive Electronics, 95520 Osny (FR)
(72) Inventeur: Le Gouil, Jean-Yves, 95280 Jouy-Le-Moutier (FR)
(74) Mandataire: Fruchard, Guy

(56) Documents cités:
- EP-A- 0 197 817
- DE-B- 1 063 226
- US-A- 3 165 672
- US-A- 5 142 441
- US-A- 5 605 715
- "SUBMERGED HEATSINK COMPONENT COOLING" IBM TECHNICAL DISCLOSURE BULLETIN,US,IBM CORP. NEW YORK, vol. 34, no. 12, 1 mai 1992 (1992-05-01), pages 387-388, XP000308563 ISSN: 0018-8689

## Description

La présente invention concerne les modules électroniques comportant un substrat et au moins un composant électronique de puissance exigeant un refroidissement. Elle trouve une application particulièrement importante, bien que non exclusive, dans le domaine de l'électronique automobile ont certains systèmes incorporent des composants de puissance, tels que des bobines ou condensateurs, qui dissipent une énergie thermique importante en fonctionnement et sont placés dans une ambiance à température élevée.

La Demande de Brevet Europeen EP-A-0 197 817 et la publication IBM TECHNICAL DISCLOSURE BULLETIN, US, IBM CORP. NEW YORK, vol. 34, no.12, 1 mai 1992, pages 387-388, XP000308563 montrent des modules électroniques exigeant un refroidissement.

L'invention concerne particulièrement les modules comprenant un substrat métallique dont une face est isolée et porte des pistes de liaison électrique et comprenant au moins un composant de puissance fixé au substrat et ayant des pattes de jonction soudées aux pistes. On utilise maintenant de tels substrats dont la face est isolée par formation d'une couche isolante, par exemple par oxydation, nitruration ou anodisation. Jusqu'ici, on monte généralement les composants sur la face isolée du substrat, ce qui ne pose pas de problème pour les composants minces à faible dissipation de chaleur. En revanche le montage de composants de puissance sur cette face, opposée à la face non isolée contre laquelle on fait circuler un fluide de refroidissement, augmente notablement l'encombrement du module.

La présente invention vise notamment à fournir un module électronique de puissance refroidi présentant un encombrement réduit. Elle propose dans ce but un module dont le composant de puissance est fixé sur la face non isolée et est placé dans un boîtier constituant une paroi interne d'un circuit de fluide de refroidissement ou collé à une telle paroi et dont les pattes traversent le substrat par des trous de ce dernier.

En règle générale, le composant de puissance sera enrobé dans une résine, permettant l'écoulement de chaleur vers le boîtier, qui pourra être électriquement isolante. Lorsque le boîtier est collé à la paroi interne du circuit de refroidissement, on utilisera en général une résine de même nature pour ce collage.

Les pattes de liaison peuvent être isolées, de façon à simplifier la traversée du substrat. Toutefois il est également possible d'utiliser des pattes en métal nu, à condition que la paroi des trous soit isolée (par exemple par oxydation) on qu'un oeillet isolant soit interposé entre chaque patte et la paroi du trou correspondant.

L'invention propose également un procédé de fabrication d'un module électronique, suivant lequel on réalise un substrat métallique dont une face est isolée et porte des pistes de liaison électrique, percé de trous de passage, on monte un composant de puissance sur la paroi non isolée du substrat en faisant passer les pattes de liaison du composant à travers les trous du substrat et on soude les pattes contre des plages des pistes placées à proximité des trous.

Pour faciliter le montage du composant de puissance et la fixation des pattes, ces pattes sont avantageusement préformées avant montage du composant et les trous ont une dimension suffisante pour livrer passage aux pattes coudées. On peut notamment constituer des trous ayant une partie large destinée à livrer passage à une patte et une partie étroite dans laquelle on amène la patte par déplacement transversal du composant avant soudage des pattes. Le composant peut être muni d'un pion prévu pour s'engager dans un trou oblong du substrat et s'y encliqueter lorsque le composant est dans sa position définitive de façon à le retenir provisoirement jusqu'à un soudage, effectué par exemple par refusion.

Les caractéristiques ci-dessus de l'invention ainsi que d'autres apparaîtront mieux à la lecture de la description qui suit d'un mode particulier de réalisation, donné à titre d'exemple non limitatif.
- La figure 1 est une représentation simplifiée, en coupe, d'une fraction d'un module suivant l'invention, l'échelle n'étant pas respectée pour plus de clarté;
- la figure 2 est une vue de dessus montrant une forme possible des pattes d'un composant de puissance et des trous pratiqués dans le substrat ;
- la figure 3 montre une forme possible d'oeillets d'isolement d'une patte.

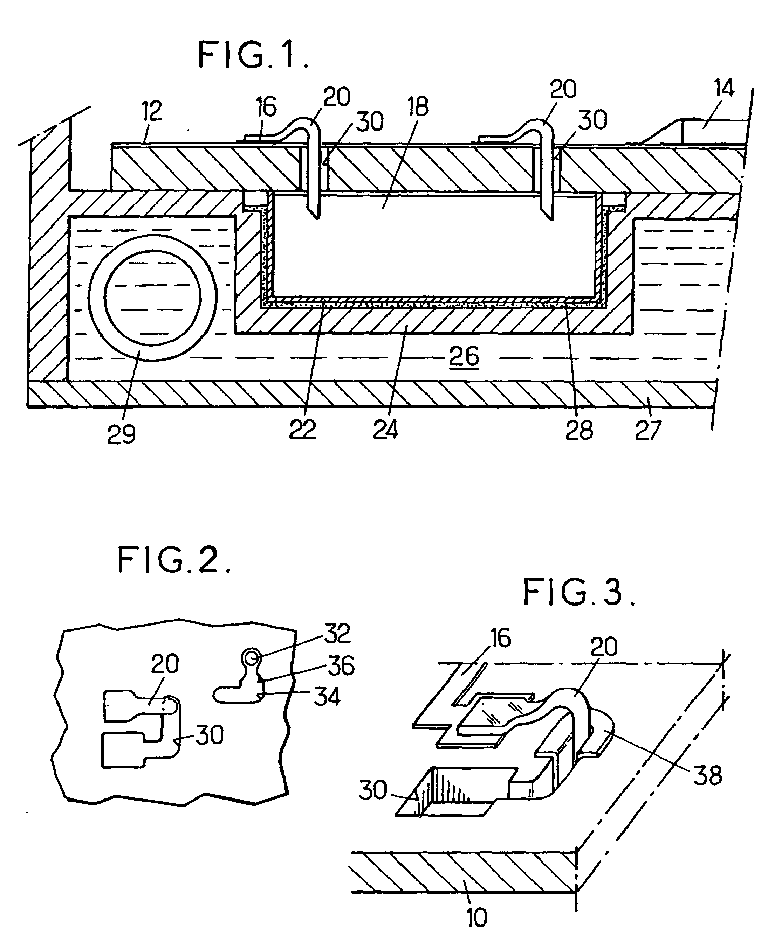

Le module dont une fraction est montrée en figure 2 comporte un substrat métallique 10, par exemple en aluminium, constitué par une plaque dont une des faces est recouverte d'une couche isolante. Cette couche est par exemple constituée par une oxydation superficielle qui peut être obtenue par traitement d'anodisation. Cette couche 12 peut avoir une épaisseur limitée à quelques dizaines de microns. La figure montre un composant électronique 14 monté sur la face isolée du substrat 10 de façon classique. La couche isolante 12 porte des pistes métallisées 16 constituant des liaisons équipotentielles auxquelles sont raccordés par soudage les différents composants portés par le substrat.

En plus des composants qui ne véhiculent que des signaux de faible puissance, le module porte un ou plusieurs composants de puissance 18 tels que par exemple des bobines de self inductance, des condensateurs, etc. Le composant 18 représenté est par exemple une bobine comportant deux pattes de liaison 20. La bobine est noyée dans un enrobage de résine, par exemple d'araldite qui peut contenir des charges destinées à accroître sa conductivité thermique. Cette bobine est contenue dans un boîtier 22 dont la face extérieure au moins présente un bon état de surface, de façon à faciliter les transferts thermiques avec la paroi interne 24 d'une boîte à eau 26 destinée à assurer le refroidissement des composants de puissance. Une résine d'enrobage 28, également présentant des charges de façon à être conductrice de la chaleur, solidarise le boîtier à la paroi interne 24 de la boîte à eau. La boîte à eau 26 est fermée par un couvercle 27, par exemple soudé et elle comporte des raccords tels que 29.

Les pattes 20 de liaison du composant 18 traversent des trous 30 du substrat 10. Ces pattes peuvent être en cuivre émaillé, ce qui évite de prévoir une couche d'isolement sur la paroi des trous. Les pattes 20 sont coudées de façon que leur partie terminale puisse s'appliquer à plat contre des plages de soudage prévues sur les pistes 16.

Pour faciliter le montage, les pattes 20 sont avantageusement préformées et coudées toutes dans le même sens, comme indiqué sur la figure 1. Pour permettre le montage des composants, les trous 30 présentent alors une forme en L, comme indiqué sur la figure 2. Pour augmenter la surface de liaison entre les pistes 16 et les pattes 20, la partie terminale de ces dernières pourra être aplatie et dans ce cas chaque trou 30 devra présenter une forme adaptée à celle de la partie aplatie et élargie, comme indiqué sur la figure 2.

Pour maintenir de façon provisoire les composants 18 jusqu'au soudage, une solution consiste à les munir chacun d'un ou plusieurs tétons ou pions 32 qui s'engagent dans des trous 34 du substrat 10. Chaque trou peut présenter un rétrécissement 36 constituant un organe d'encliquetage du téton. Ainsi les pattes du composant monté sont maintenues appliquées contre les plages de liaison, généralement revêtues de matériaux de brasage pour permettre de réaliser de façon classique les soudures par refusion.

Dans la variante de réalisation montrée en figure 3, des oeillets 38 en matériau isolant sont interposés entre les pattes 20 et la paroi des trous 30, ce qui permet d'utiliser des pattes non isolées.

L'invention permet de monter, sur des substrats en aluminium de quelques millimètres d'épaisseur, des composants de puissance ayant une dimension en plan de plusieurs dizaines de millimètres et une épaisseur dépassant elle aussi 10 mm, qui donc représentent un encombrement notable et s'ajoutent à celui de la boîte à eau lorsqu'ils sont en saillie sur la face isolée. On a en particulier utilisé le montage décrit pour constituer des modules ayant des composants telles que des bobines qui, lors du fonctionnement, dégagent une puissance d'une dizaine de Watts.

## Revendications

1. Module électronique comportant un substrat métallique (10) dont une face est isolée et porte des pistes de liaison électrique (16) et comprenant au moins un composant de puissance (18) fixé au substrat (10) et ayant des pattes de jonction (20) soudées aux pistes, **caractérisé en ce que** le composant de puissance est fixé sur la face non isolée et placé dans un boîtier (22) constituant une paroi interne d'un circuit de fluide de refroidissement ou collé à elle et dont tes pattes traversent le substrat par des trous (30) de ce dernier.

2. Module selon la revendication 1, **caractérisé en ce que** le composant de puissance est enrobé dans une résine permettant l'écoulement de chaleur vers le boîtier.

3. Module selon la revendication 2, **caractérisé en ce que** la résine est électriquement isolante.

4. Module selon la revendication 3, **caractérisé en ce que** le boîtier est collé à la paroi interne du circuit de refroidissement et la résine de collage est de même nature que la résine d'enrobage.

5. Module selon la revendication 1, **caractérisé en ce que** les pattes de liaison (20) sont isolées.

6. Module selon la revendication 1, **caractérisé en ce que** la paroi des trous est isolée ou un oeillet isolant (38) est interposé entre chaque patte et la paroi du trou correspondant.

7. Procédé de fabrication d'un module électronique, suivant lequel on réalise un substrat métallique dont une face est isolée et porte des pistes de liaison électrique (16), percé de trous de passage (30), on monte un composant de puissance sur la paroi non isolée du substrat et dans un boîtier (22) constituant une paroi interne d'un circuit de fluide de refroidissement en faisant passer les pattes de liaison du composant à travers les trous du substrat et on soude les pattes contre des plages des pistes (16), placées à proximité des trous.

8. Procédé suivant la revendication 7, suivant lequel on préforme les pattes avant montage du composant et on donne aux trous une dimension suffisante pour livrer passage aux pattes coudées.

9. Procédé suivant la revendication 8, suivant lequel on constitue des trous ayant une partie large destinée à livrer passage à une patte et une partie étroite dans laquelle on amène la patte par déplacement transversal du composant avant soudage des pattes.

10. Procédé suivant la revendication 8 ou 9, suivant lequel on munit le composant d'au moins un pion (32) prévu pour s'engager dans un trou oblong du substrat et s'y encliqueter lorsque le composant est dans sa position définitive de façon à le retenir provisoirement jusqu'à un soudage, effectué par exemple par refusion.

## Patentansprüche

1. Elektronikmodul, umfassend ein metallisches Substrat (10), dessen eine Seite isoliert ist und elektrische Anschlussspuren (16) trägt, und umfassend mindestens ein Leistungsbauteil (18), das am Substrat (10) befestigt ist und an die Spuren angeschweißte Anschlussfüße (20) besitzt, **dadurch gekennzeichnet, dass** das Leistungsbauteil auf der nicht isolierten Fläche befestigt und in einem Gehäuse (22) angeordnet ist, das eine Innenwand eines Kühlfluidkreises bildet oder an sie geklebt ist, und dessen Anschlussfüße durch das Substrat durch Löcher (30) dieses letztgenannten hindurchgehen.

2. Modul nach Anspruch 1, **dadurch gekennzeichnet, dass** das Leistungsbauteil in einem Harz eingehüllt ist, das das Ableiten von Wärme zum Gehäuse ermöglicht.

3. Modul nach Anspruch 2, **dadurch gekennzeichnet, dass** das Harz elektrisch isolierend ist.

4. Modul nach Anspruch 3, **dadurch gekennzeichnet, dass** das Gehäuse an die Innenwand des Kühlkreises geklebt ist und das Klebeharz von derselben Art wie das Umhüllungsharz ist.

5. Modul nach Anspruch 1, **dadurch gekennzeichnet, dass** die Anschlussfüße (20) isoliert sind.

6. Modul nach Anspruch 1, **dadurch gekennzeichnet, dass** die Wand der Löcher isoliert ist oder eine Isolieröse (38) zwischen jedem Anschlussfuß und der Wand des entsprechenden Loches angeordnet ist.

7. Verfahren zur Herstellung eines Elektronikmoduls, nach dem ein metallisches Substrat hergestellt wird, dessen eine Seite isoliert ist und elektrische Anschlussspuren (16) trägt und das Durchgangslöcher (30) aufweist, ein Leistungsbauteil auf der nicht isolierten Wand des Substrats und in einem Gehäuse, das eine Innenwand eines Kühlfluidkreises bildet, montiert wird, indem die Anschlussfüße des Bauteils durch die Löcher des Substrats geführt werden, und die Anschlussfüße an den Bereichen der Spuren (16) geschweißt werden, die in der Nähe der Löcher angeordnet sind.

8. Verfahren nach Anspruch 7, nach dem die Anschlussfüße vor Montage des Bauteils vorgeformt werden und den Löchern eine ausreichende Abmessung verliehen wird, um den geknickten Anschlussfüßen Durchgang zu gewähren.

9. Verfahren nach Anspruch 8, nach dem Löcher gebildet werden, die einen breiten Teil, der dazu bestimmt ist, einem Anschlussfuß Durchgang zu gewähren, und einen schmalen Teil aufweisen, in den der Anschlussfuß durch Querverschieben des Bauteils vor dem Anschweißen der Anschlussfüße eingeführt wird.

10. Verfahren nach Anspruch 8 oder 9, nach dem das Bauteil mit mindestens einem Metallstück (32) versehen ist, das dazu vorgesehen ist, in ein Langloch des Substrats einzugreifen und hier einzurasten, wenn sich das Bauteil in seiner endgültigen Position befindet, um es provisorisch bis zu einem Anschweißen, das beispielsweise durch Umschmelzen durchgeführt wird, zu halten.

## Claims

1. An electronic module comprising a metal substrate (10) having one face that is insulated and that carries electrical connection tracks (16), and comprising at least one power component (18) fixed to the substrate (10) and having connection tabs (20) that are soldered to the tracks, the module being **characterized in that** the power component is fixed on the non-insulated face and is placed in a housing (22) constituting an inside wall of a cooling fluid circuit or is stuck to such a wall, and its tabs pass through the substrate via holes (30) therein.

2. A module according to claim 1, **characterized in that** the power component is potted in a resin enabling heat to be transferred to the housing.

3. A module according to claim 2, **characterized in that** the resin is electrically insulating.

4. A module according to claim 3, **characterized in that** the housing is stuck to the inside wall of the cooling circuit, and the adhesive resin is of the same kind as the potting resin.

5. A module according to claim 1, **characterized in that** the connection tabs (20) are insulated.

6. A module according to claim 1, **characterized in that** the walls of the holes are insulated or respective insulating eyelets (38) are interposed between each tab and the wall of the corresponding hole.

7. A method of manufacturing an electronic module, in which a metal substrate is formed having one face that is insulated, and that carries electrical connection tracks (16), the substrate being pierced by through holes (30), a power component is mounted on the non-insulated wall of the substrate and in a housing (22) constituting an inside wall of the cooling liquid circuit, with connection tabs of the component passing through holes in the substrate, and the tabs are soldered to areas of the tracks (16) located close to the holes.

8. A method according to claim 7, in which the tabs are preformed prior to the component being mounted, and the holes are large enough to allow the angled tabs to pass therethrough.

9. A method according to claim 8, in which holes are made each having a large portion for allowing a tab to pass through and a narrow portion into which the tab is brought by moving the component sideways prior to soldering the tabs.

10. A method according to claim 8 or 9, in which the component is provided with at least one peg (32) designed to engage in an oblong hole of the substrate and to snap-fasten therein when the component is in its final position so as to hold the component temporarily until soldering has been performed, e.g. by the reflow technique.
